# EUROPÄISCHE PATENTANMELDUNG

(11) **EP 2 421 153 A1**
(43) Veröffentlichungstag der Anmeldung: **22.02.2012**
(21) Anmeldenummer: 10173088.5
(22) Anmeldetag: 17.08.2010
(51) Int. Cl.: H03K 17/955, H03K 17/96

(54) **Reflektor**

(71) Anmelder: RAFI GmbH & Co. KG, 88276 Berg (DE)
(72) Erfinder: Beckert, Andreas, 88379 Unterwalthausen (DE); Merz, Roland, 88214 Ravensburg (DE)
(74) Vertreter: Engelhardt & Engelhardt

(57) **Zusammenfassung**

Bei einem Reflektor (1) mit einem parabolisch gekrümmten Schalenkörper (2) durch den Lichtwellen (4) definiert gebündelt sind und mit einer auf der Innenseite des Schalenkörpers (2) aufgebrachten Metallschicht (5), soll zum einen die Fokussierungseigenschaften des Reflektors (1) bezüglich der Lichtwellen (4) erhalten bleiben und gleichzeitig soll zum anderen der Reflektor (1) ein kapazitives Feld (13) erzeugen, dessen Wertveränderung zur Generierung eines elektrisches Schaltsignals verwendet werden können.

Dies wird dadurch erreicht, dass die Metallschicht (5) mittels einer Leitung (7) elektrisch an einer Leiterplatte (11) angeschlossen ist, dass die Metallschicht (5) ein kapazitives Feld (13) erzeugt und dass Veränderungen des kapazitiven Feldes (13), vorzugsweise beim Eindringen eines elektrisch leitenden Gegenstandes (16), mittels mindestens einem integrierten Schaltkreis (12) zur Erzeugung eines elektrischen Schaltsignales ausgewertet sind.

## Beschreibung

Die Erfindung bezieht sich auf einen Reflektor nach dem Oberbegriff des Patentanspruches 1.

Derartige Reflektoren aus Metall können beispielsweise der DE 10 2004 049 134 A1 entnommen werden. Diese Reflektoren weisen einen parabolisch gekrümmten Schalenkörper auf, der als Träger für die aufzubringende Metallschicht dient. Aufgrund der parabolischen Ausbildung des Reflektors ist in dessen Lichtbrechungszentrum ein Leuchtmittel angeordnet. Das Leuchtmittel emittiert Lichtwellen, die von der Metallschicht reflektiert und somit definiert gebündelt werden. Solche Reflektoren dienen demnach als Lichtprojektoren, die eine gute optische Funktion aufweisen, indem die emittierten Lichtwellen durch den Reflektor mit einer hohen Präzision gebündelt sind.

Solche Reflektoren haben sich insbesondere für Projektoren in der Praxis bewährt. Gleichwohl weisen solche Reflektoren ausschließlich die physikalische Eigenschaft auf, die Lichtwellen hoch präzise zu fokussieren.

Der Patentanmelderin ist bislang nicht bekannt, dass solche Reflektoren auch als Taster oder Schalter, die in Bedienfelder von elektrisch zu betreibenden Geräten oder Maschinen eingesetzt werden können, existieren.

Es ist daher Aufgabe der Erfindung, einen Reflektor der eingangs genannten Gattung derart weiterzubilden, dass zum Einen die Fokussierungseigenschaften des Reflektors bezüglich der Lichtwellen erhalten bleiben und gleichzeitig zum Anderen der Reflektor ein kapazitives Feld erzeugt, dessen Wertveränderungen zur Generierung eines elektrischen Schaltsignales verwendet werden können.

Diese Aufgaben sind erfindungsgemäß durch die Merkmale des kennzeichnenden Teils von Patentanspruch 1 gelöst.

Weitere vorteilhafte Weiterbildungen der Erfindung ergeben sich aus den Unteransprüchen.

Es ist besonders vorteilhaft, die auf dem Schichtkörper aufgebrachte Metallschicht mittels einer elektrischen Leitung, also galvanisch, an eine Leiterplatte anzuschlie-βen, um die Metallschicht als Kondensatorplatte zu benutzen. Folglich kann durch den Reflektor nicht nur Licht fokussiert werden, sondern auch ein kapazitives Feld entstehen, so dass beim Eindringen, beispielsweise eines menschlichen Fingers, eine zweite Kondensatorplatte in das kapazitive Feld eindringt.

Die Metallschicht des Reflektors ist mit einem integrierten Schaltkreis elektrisch gekoppelt, so dass durch den integrierten Schaltkreis ermittelbar ist, wann eine Veränderung des kapazitiven Feldes stattfindet. Die Auswertung des kapazitiven Feldes durch den integrierten Schaltkreis kann dann anschließend dazu genutzt werden, ein elektrisches Schaltsignal zu generieren.

Aufgrund der parabolischen Ausgestaltung des Reflektors entsteht zudem ein homogenes kapazitives Feld, denn durch die Krümmung des Reflektors wird auch das kapazitive Feld nahezu gleichmäßig in Richtung des Schaltfeldes abgestrahlt.

In der Zeichnung ist ein erfindungsgemäßes Ausführungsbeispiel dargestellt, das nachfolgend näher erläutert ist. Im Einzelnen zeigt:
- Figur 1: einen Reflektor, der in einem Gehäuse eingebaut ist und dessen Metallschicht elektrisch mit einer Leiterplatte und einem integrierten Schaltkreis verbunden ist, in perspektivischer Ansicht,
- Figur 2: den Reflektor gemäß Figur 1, im Schnitt und
- Figur 3: den Reflektor gemäß Figur 2, in dessen Metallschicht eine um die Längsachse des Reflektors umlaufende Nut eingearbeitet ist zur Erzeugung eines redundanten Schalters.

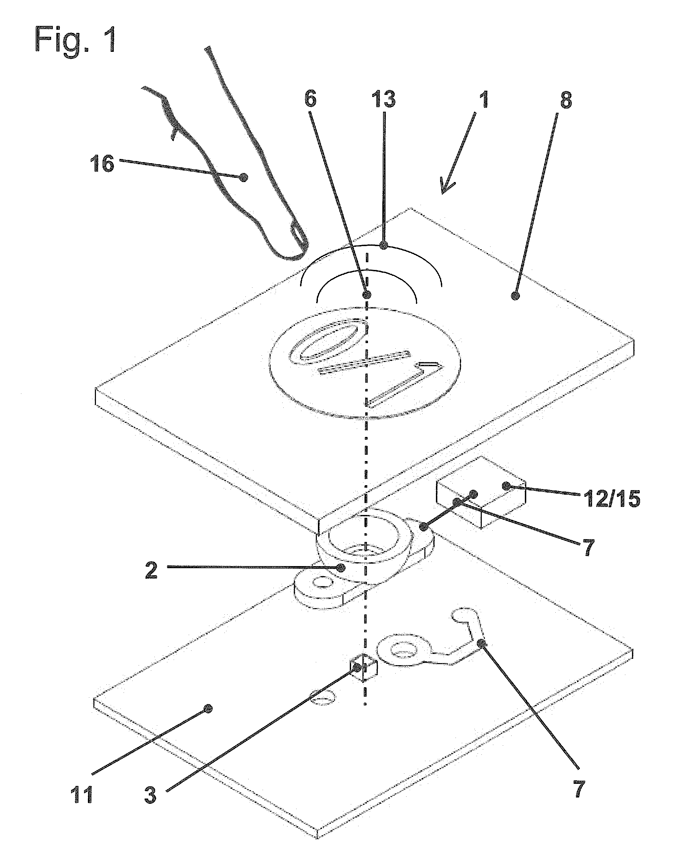

In Figur 1 ist ein Reflektor 1 zu entnehmen, der einen parabolisch gekrümmten Schalenkörper 2 aufweist. Solche Reflektoren 1 dienen zur Lichtprojektion, so dass in deren Brechungszentrum eine LED 3 angeordnet ist, durch die Lichtwellen 4 emittiert werden. Die Lichtwellen 4 treffen auf eine an der Innenseite des Schalenkörpers 2 aufgebrachten Metallschicht 5, die besondere gute Reflektions- und Fokussierungseigenschaften aufweist, auf, so dass diese durch die Metallschicht 5, die auf dem Schalenkörper 2 aufgebracht ist, reflektiert sind.

Die Längsachse 6 des Reflektors 1 stellt dabei die Symmetrieachse des Reflektors 1 dar.

Die vorhandene Metallschicht 5 soll nunmehr erfindungsgemäß ein kapazitives Feld 13 ausbilden. Zu diesem Zweck ist der Reflektor 1 elektrisch mit einer Leiterplatte 11 verbunden, und zwar insbesondere derart, dass sowohl die LED 3 als auch die Metallschicht 5 elektrisch an die Leiterplatte 11 gekoppelt ist. Die Metallschicht 5 erzeugt demnach das kapazitive Feld 13 und wirkt als eine Kondensatorplatte.

Sobald nun ein elektrisch leitfähiger Gegenstand 16, beispielsweise ein menschlicher Finger, in das kapazitive Feld 13 eindringt, verändert sich die Kapazität, die durch einen integrierten Schaltkreis 12 erfasst sind. Der integrierte Schaltkreis 12 ist elektrisch über eine Leitung 7 mit der Leiterplatte 11 und der Metallschicht 5 verbunden. Sobald eine Veränderung des kapazitiven Feldes 13 durch den integrierten Schaltkreis 12 festgestellt wurde, kann ein elektrisches Schaltsignal erzeugt werden.

Der Reflektor 1 ist unterhalb einer Platte 8 angeordnet, die in einem Gehäuserahmen 8', der schematisch dargestellt ist, befestigt ist. Durch die Platte 8 und den Gehäuserahmen 8' wird somit der Reflektor 1 und die im Inneren des Gehäuserahmens 8' angeordnete Leiterplatte 11 nach außen abgeschirmt, so dass keine Schmutzpartikel an die Leiterplatte 11 und dem Reflektor 1 gelangen.

Das freie Ende des Reflektors 1 liegt entweder an der Innenseite der Platte 8 an oder ist beabstandet zu dieser angeordnet, so dass zwischen dem Reflektor 1 und der Innenseite der Platte 8 ein Luftspalt 9 vorgesehen ist.

Die Platte 8 ist aus einem transparenten Material, vorzugsweise aus Glas oder Kunststoff, hergestellt. Die Platte 8 übt keinerlei elektrischen Einfluss auf das kapazitive Feld 13 aus, so dass dieses vielmehr ungehindert durch die Platte 8 hindurch dringt und von außen mittels des Gegenstandes 16 beeinflusst werden kann.

Um die Bedienung des jeweiligen Reflektors 1 zu vereinfachen, ist zwischen der Platte 8 und dem Reflektor 1 ein Streifen 10 vorgesehen, der mit Symbolen in Form von Buchstaben, Zahlen oder dgl. beschriftet ist.

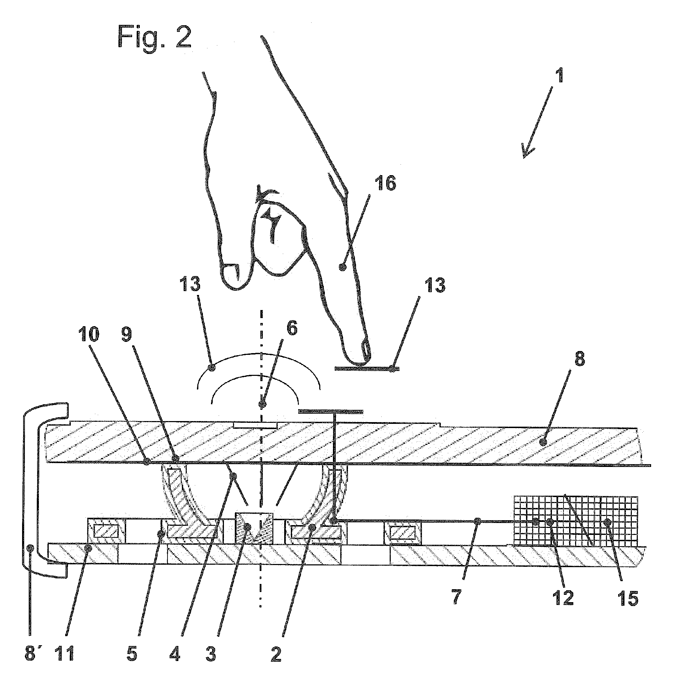

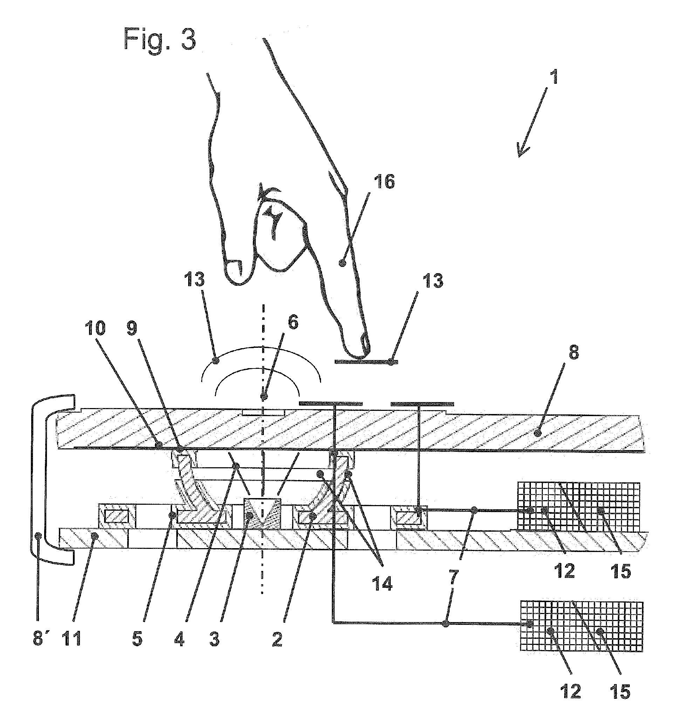

In Figur 3 ist eine Weiterbildung des Reflektors nach den Figuren 1 und 2 zu entnehmen. In die Metallschicht 5 ist nämlich eine um die Längsachse 6 mit einem konstanten Abstand umlaufende Nut 14 eingearbeitet, so dass die Metallschicht 5 in zwei Bereiche unterteilt ist. Beide Bereiche der Metallschicht 5 können von einem der integrierten Schaltkreise 12 überwacht werden. Die beiden Bereiche der Metallschicht 5 erzeugen demnach unterschiedliche kapazitive Felder 13. Aufgrund der beiden unterschiedlichen Felder 13 und der unabhängigen Auswertung der Werteveränderung dieser kapazitiven Felder 13 durch die beiden integrierten Schaltkreise 12 ist ein redundanter Schalter geschaffen, denn erst wenn beide integrierte Schaltkreise 12 an eine Auswerteeinheit 15 ein entsprechende Signal aussenden, erfolgt die Generierung eines elektrischen Schaltsignals.

## Patentansprüche

1. Reflektor (1) mit einem parabolisch gekrümmten Schalenkörper (2) durch den Lichtwellen (4) definiert gebündelt sind und mit einer auf der Innenseite des Schalenkörpers (2) aufgebrachten Metallschicht (5),
**dadurch gekennzeichnet,**
**dass** die Metallschicht (5) mittels einer Leitung (7) elektrisch an einer Leiterplatte (11) angeschlossen ist, dass die Metallschicht (5) ein kapazitives Feld (13) erzeugt und dass Veränderungen des kapazitiven Feldes (13), vorzugsweise beim Eindringen eines elektrisch leitenden Gegenstandes (16), mittels mindestens einem integrierten Schaltkreis (12) zur Erzeugung eines elektrischen Schaltsignales ausgewertet sind.

2. Reflektor nach Anspruch 1,
**dadurch gekennzeichnet,**
**dass** die Metallschicht (5) aus Chrom hergestellt ist.

3. Reflektor nach Anspruch 1 oder 2,
**dadurch gekennzeichnet,**
**dass** der Reflektor (1) unmittelbar auf der Leiterplatte (11) angebracht und mit dieser elektrisch verbunden ist.

4. Reflektor nach einem der vorgenannten Ansprüche,
**dadurch gekennzeichnet,**
**dass** in die Metallschicht (5) eine Nut (14) eingearbeitet ist, die beabstandet um die Längsachse (6) des Reflektors (1) in der Metallschicht (5) verläuft und die einen konstanten Abstand zu der Längsachse (6) aufweist.

5. Reflektor nach Anspruch 4,
**dadurch gekennzeichnet,**
**dass** die beiden voneinander getrennten Metallschichten (5) jeweils gesondert an einem integrierten Schaltkreis (12) zur Bestimmung des kapazitiven Feldes (13) angeschlossen sind und dass mittels einer Auswerteeinheit (15) die Messsignale der beiden integrierten Schaltkreise (12) zur Erzeugung eines redundanten Schaltsignales ausgewertet sind.

6. Reflektor nach einem der vorgenannten Ansprüche,
**dadurch gekennzeichnet,**
**dass** die Metallschicht (5) galvanisiert ist.

7. Reflektor nach einem der vorgenannten Ansprüche,
**dadurch gekennzeichnet,**
**dass** der Reflektor (1) auf der der Leiterplatte (11) gegenüberliegenden Seite mittels einer transparenten Platte (8) abgedeckt ist und dass der Reflektor (1) unmittelbar an der Platte (8) anliegt oder dass zwischen der Platte (8) und dem Reflektor (1) ein Luftspalt (9) vorgesehen ist.

8. Reflektor nach Anspruch 7,
**dadurch gekennzeichnet,**
**dass** die Platte (8) aus Glas oder Kunststoff hergestellt ist.

9. Reflektor nach Anspruch 7,
**dadurch gekennzeichnet,**
**dass** zwischen dem freien Ende des Reflektors (1) und der Platte (8) ein transparenter dünnwandiger Streifen (10) angeordnet ist und dass auf dem Streifen (10) Symbole in Form von Zahlen, Buchstaben oder dergleichen aufgedruckt sind.

10. Reflektor nach Anspruch 7,
**dadurch gekennzeichnet,**
**dass** die Platte (8) in dem Bereich des Reflektors (1) eben, gewölbt oder stufenförmig ausgebildet ist.

11. Reflektor nach einem der vorgenannten Ansprüche,
**dadurch gekennzeichnet,**
**dass** eine Vielzahl von Reflektoren (1) nach den Ansprüchen 1 bis 10 auf der gemeinsamten Leiterplatte (11) zur Bildung eines Tastenfeldes angeordnet sind und dass mittels der Reflektoren (1) jeweils unterschiedliche Schaltsignale zur Steuerung einer mit dem Tastenfeld verbundenen elektrisch zu betreibenden Vorrichtung bedienbar ist.
